Europäisches Patentamt

European Patent Office

Office européen des brevets

(19)

(11) Numéro de publication: **0 269 468**
**B1**

(12) # FASCICULE DE BREVET EUROPEEN

(45) Date de publication du fascicule du brevet:
**22.11.90**

(51) Int. Cl.⁵: **G11C 17/00,** G11C 7/00,
G06F 1/00

(21) Numéro de dépôt: **87402153.8**

(22) Date de dépôt: **28.09.87**

(54) Dispositif de sécurité pour la programmation d'une mémoire non volatile programmable électriquement.

(30) Priorité: **30.09.86 FR 8613575**

(43) Date de publication de la demande:
**01.06.88 Bulletin 88/22**

(45) Mention de la délivrance du brevet:
**22.11.90 Bulletin 90/47**

(84) Etats contractants désignés:
**DE ES FR GB IT**

(56) Documents cités:
**US-A- 4 295 041**

**IBM TECHNICAL DISCLOSURE BULLETIN,
vol. 25, no. 11A, avril 1983, pages 5827,5828, New York,
US; R.D. BURKE: "Write driver for a random-access
memory"
PATENT ABSTRACTS OF JAPAN,
vol. 8, no. 60 (P-262)[1497], 22 mars 1984; &
JP-A-58 208 991 (NIPPON DENKI K.K.) 05-12-1983
ELECTRONIQUE ET MICROELECTRONIQUE
INDUSTRIELLES,
no. 215, 15 février 1976, pages 19-24, Paris, FR; H.
LILEN: "Qu'est-ce qu'un réseau logique programmable
(PLA) ?"**

(73) Titulaire: **THOMSON COMPOSANTS MILITAIRES ET
SPATIAUX, 173, Bd Haussmann, F-75008 Paris(FR)**

(72) Inventeur: **Fruhauf, Serge, THOMSON-CSF
SCPI 19, avenue de Messine, F-75008 Paris(FR)**
Inventeur: **Marquot, Alexis, THOMSON-CSF
SCPI 19, avenue de Messine, F-75008 Paris(FR)**

(74) Mandataire: **Ruellan-Lemonnier, Brigitte et al,
THOMSON-CSF SCPI, F-92045 PARIS LA DEFENSE
CEDEX 67(FR)**

**Description**

La présente invention concerne les mémoires non volatiles programmables électriquement nécessitant un courant de programmation telles que, par exemple, les mémoires EPROM ou EEPROM. Elle concerne plus particulièrement un dispositif de sécurité pour la programmation de ces mémoires.

En général, dans les mémoires du type EPROM ou EEPROM, chaque élément du stockage d'information ou cellule-mémoire est constitué par un transistor MOS à grille flottante. Un transistor MOS à grille flottante peut avoir deux états. Pour un transistor MOS à canal N, dans un premier état aucune charge n'est piégée sur la grille flottante. Un canal de conduction peut exister entre source et drain. Le transistor conduit alors et se comporte comme un interrupteur fermé. Dans un deuxième état les électrons ont été piégés sur la grille flottante. Ils empêchent la création d'un canal de conduction dans le substrat entre source et drain. Dans ce cas, le transistor est bloqué et se comporte comme un interrupteur ouvert.

Pour programmer un transistor MOS à grille flottante tel que décrit ci-dessus, des tensions plus élevées que la tension de fonctionnement normal doivent être appliquées sur la grille de commande et l'une des électrodes de sorte que la grille flottante puisse absorber et garder une charge d'électrons. D'autre part, pour lire une mémoire ainsi programmée, une tension de lecture spécifique doit être appliquée sur la grille de commande, cette tension de lecture permettant de détecter l'état passant ou bloqué du transistor.

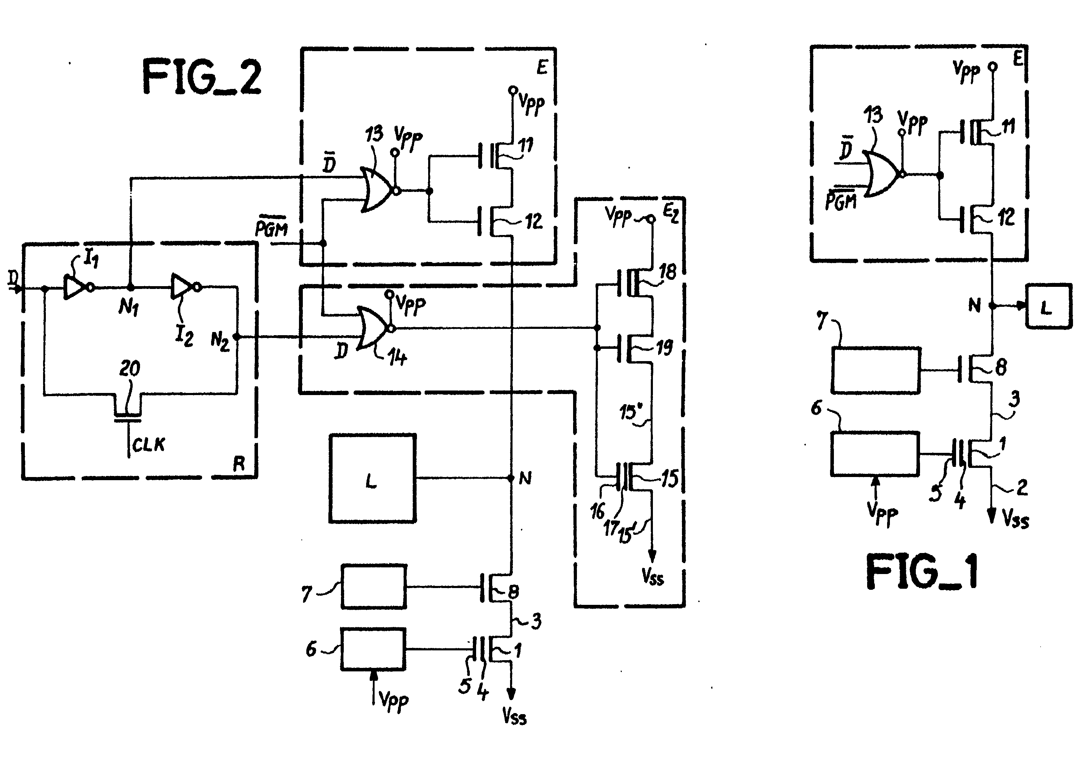

Pour pouvoir appliquer les tensions nécessaires à la programmation ou à la lecture d'une cellule mémoire constituée par un transistor MOS à grille flottante, celui-ci est en général connecté de la manière représentée sur la figure 1. Ainsi, une des électrodes principales du transistor MOS 1 à grille flottante, à savoir la source 2 dans le mode de réalisation représenté, est reliée à la tension Vss représentant la masse tandis que l'autre électrode ou drain 3 est relié par l'intermédiaire d'une ligne de bits non représentée et d'un transistor MOS formant interrupteur 8 à un décodeur d'adresses de colonnes 7. La grille de commande 5 du transistor MOS 1 est reliée par l'intermédiaire d'une autre connexion dite ligne de mots, non représentée, à un décodeur d'adresses de lignes 6. Les lignes de bits et lignes de mots sont arrangées en lignes et en colonnes pour déterminer une matrice incluant le cellule mémoire constituée par le transistor MOS 1 à grille flottante de manière connue de l'homme de l'art. En fait, le décodeur d'adresses de colonnes 7 est relié à la grille du transistor 8 dont la source est reliée au drain 3 du transistor 1 tandis que son drain est connecté respectivement au circuit d'écriture E et à un circuit de lecture symbolisé par le bloc L.

Le circuit d'écriture E est réalisé de manière qu'une tension correspondant sensiblement à la tension de commande d'écriture, à savoir la tension Vpp, soit appliquée au niveau du noeud N lorsque la cellule mémoire 1 doit être programmée, c'est-à-dire lorsqu'elle doit enregistrer une donnée correspondant par exemple à un "1". Au contraire, si la cellule mémoire 1 ne doit pas être programmée, la tension au noeud N pendant l'écriture est flottante. Comme représenté sur la figure 1, le circuit d'écriture peut être constitué par une charge comprenant un transistor MOS 11 déplété dont l'une des électrodes est reliée à la tension Vpp constituant la tension de commande d'écriture et dont l'autre électrode est reliée à une des électrodes d'un transistor MOS 12 enrichi. L'autre électrode du transistor 12 est connectée au noeud N. Les deux grilles des transistors 11 et 12 sont reliées en commun à un circuit de commande de programmation constitué par une porte NOR (subséquent nommée porte NI) 13 alimentée à la tension Vpp. Cette porte NI 13 reçoit respectivement sur ses deux entrées un signal $\overline{D}$ correspondant à la donnée à programmer inversée, et un signal $\overline{PGM}$ correspondant au signal de programmation inversé. En conséquence, avec le circuit ci-dessus on n'obtient une tension sensiblement égale à la tension Vpp au point N que si les signaux $\overline{D}$ et $\overline{PGM}$ sont tous deux à zéro, c'est-à-dire que le circuit d'écriture est ouvert si la donnée D vaut "1" et est bloqué si la donnée D vaut "0", dans le mode de réalisation choisi à titre d'exemple. En fait, on ne consomme du courant au niveau de Vpp que lorsqu'on programme le transistor MOS 1 à grille flottante. Aussi, en observant la variation du courant d'écriture dans une mémoire, on peut reconnaître facilement si on programme un niveau logique "1" ou un niveau logique "0" à une adresse donnée.

Ceci est particulièrement gênant dans le cas des mémoires utilisées pour recevoir des informations confidentielles car il est alors facile de détecter, lors de leur programmation, la teneur de ces informations.

La présente invention a pour but de remédier à cet inconvenient en proposant un dispositif de sécurité qui ne permet pas de détecter la programmation d'un "1" ou d'un "0" dans une mémoire non volatile programmable électriquement nécessitant un courant de programmation.

La présente invention a en conséquence pour objet un dispositif de sécurité pour la programmation d'une mémoire non volatile programmable électriquement, la mémoire étant constituée par une matrice de cellules-mémoire accessibles chacune par des lignes et des colonnes et reliées à des circuits d'écriture et de lecture permettant respectivement de les programmer dans deux états "1" ou "0" selon les données en entrée et de lire l'état programmé, les cellules mémoire étant du type nécessitant un courant de programmation pour être programmées dans un premier état ou "1" et ne demandant aucun courant pour être programmées dans un second état ou "0", caractérisé en ce qu'il est constitué par un circuit de simulation activé par les données correspondant à une programmation à "0" et débitant un courant identique à celui d'une cellule mémoire en condition de programmation à "1".

Différents modes de réalisation peuvent être utilisés pour ce circuit de simulation. Selon un premier mode de réalisation, le circuit de simulation est constitué par une cellule-mémoire supplémentaire connectée à un deuxième circuit d'écriture parallèle au premier circuit d'écriture et activé par une donnée correspondant à une programmation à "0". De manière plus spécifique, le deuxième circuit d'écriture est constitué par une charge comprenant un transistor MOS déplété monté en série avec un transistor MOS enrichi, les grilles des deux transistors étant connectées en commun et reliées à un circuit d'activation appliquant la tension de commande d'écriture pour les données correspondant à une programmation à "0", la charge étant connectée entre la tension de commande d'écriture et la cellule-mémoire supplémentaire dont la grille est connectée directement ou par l'intermédiaire d'un soustracteur avec les grilles des deux transistors formant charge.

Selon un autre mode de réalisation, le circuit de simulation est constitué par une cellule-mémoire supplémentaire connectée au circuit d'écriture de la mémoire de manière à recevoir un courant de programmation pour les données correspondant à une programmation a "0". Dans ce cas, le circuit d'écriture est constitué par une charge comprenant un transistor MOS déplété monté en série avec un transistor MOS enrichi, les grilles deux transistors étant connectées en commun et reliées à la tension de commande d'écriture, la charge étant connectée entre la tension de commande d'écriture et respectivement les cellules-mémoire de la zone mémoire et la cellule-mémoire supplémentaire par l'intermédiaire de portes ET commandées soit par les données correspondant à une programmation à "1" soit par les données correspondant à une programmation à "0".

Selon une autre caractéristique de la présente invention, la cellule-mémoire supplémentaire est constituée comme les cellules-mémoire par des transistors MOS à grille flottante. Toutefois, la cellule-mémoire supplémentaire est une cellule mémoire programmée puisque la même cellule est utilisée pour un ensemble de cellules-mémoire du plan mémoire. Or, une cellule-mémoire déjà programmée présente une courbe de consommation de courant différente d'une cellule-mémoire vierge. En effet, une cellule mémoire vierge d'une mémoire non volatile présente une pointe de consommation de courant d'environ 2 % en début de programmation, pointe qui est pratiquement résorbée après deux millisecondes. Or, cette pointe de consommation n'existe plus dans le cas où la cellule est reprogrammée. Toutefois, dans les mémoires non volatiles programmables électriquement actuellement utilisées, on programme toujours un octet soit huit positions binaires en parallèle ; or sur huit positions binaires la différence de courant entre une cellule vierge et une cellule programmée en condition de programmation est très difficilement décelable. D'autre part, le courant moyen d'une cellule vierge en programmation et d'une cellule déjà programmée est sensiblement le même car on positionne la droite de charge dans la zone appelée en langue anglaise "snap back" de la cellule. En conséquence, l'utilisation pour la cellule-mémoire supplémentaire d'un transistor MOS à grille flottante donne en général de bons résultats et ne permet pas de différencier la programmation à "1" ou "0". Toutefois, notamment lorsqu'on réalise une programmation bit par bit, on utilise de préférence une cellule-mémoire supplémentaire constituée par un transistor MOS à grille flottante dont la grille flottante est court-circuitée avec la grille de commande et qui présente la même tension grille-source que les autres cellules-mémoire.

Les caractéristiques et avantages de la présente invention apparaîtront à la lecture de la description de divers modes de réalisation faite ci-après avec référence aux-dessins ci-annexés dans lesquels :

- la figure 1, déjà décrite, représente schématiquement une cellule mémoire d'une mémoire EPROM connectée à ses circuits de commande,
- la figure 2 représente schématiquement un mode de réalisation d'une cellule-mémoire d'une mémoire EPROM connectée à ses circuits de commande comprenant un dispositif de sécurité conforme à la présente invention,
- la figure 3 représente schématiquement une variante de réalisation du dispositif de sécurité, et
- la figure 4 représente schématiquement un autre mode de réalisation d'une cellule mémoire d'une mémoire EPROM connectée à ses circuits de commande et comprenant un dispositif de sécurité conforme à la présente invention.

Pour simplifier la description, dans les dessins les mêmes éléments portent les mêmes références. D'autre part, la description a été faite en se référant à des circuits MOS réalisés en technologie NMOS, il est évident pour l'homme de l'art que la présente invention peut s'adapter à d'autres technologies. La mémoire décrite est une mémoire EPROM dont les cellules-mémoires sont constituées par des transistors MOS à grille flottante de type SAMOS (pour stocked gate avalanche injection MOS). La présente invention peut aussi s'appliquer à des transistors MOS de type FAMOS (pour floating gate avalanche injection MOS).

Ainsi, comme représenté sur la figure 2, une cellule-mémoire constituée par le transistor MOS à grille flottante est connectée, de la même manière que dans le mode de réalisation de la figure 1, à un décodeur d'adresses de lignes 6, un décodeur d'adresses de colonnes 7, un circuit de lecture L et un circuit d'écriture E. En conséquence, ces différents circuits ne seront pas redécrits. Conformément à la présente invention, la mémoire EPROM schématisée par sa cellule mémoire 1 comporte de plus un dispositif de sécurité qui empêche la détection d'une programmation de "1" ou de "0".

Comme représenté sur la figure 2, le dispositif de sécurité est constitué essentiellement par un circuit de simulation E2 comprenant une cellule mémoire 15 constituée par un transistor MOS à grille flottante dont l'une des électrodes principales ou source 15' est reliée à la tension $V_{SS}$ et dont l'autre électrode principale ou drain 15" est reliée à une charge constituée des deux transistors MOS 18 et 19. De manière plus spécifique, le transistor MOS 18 est un transistor déplété tandis que le transistor MOS 19 est un transistor enrichi. Ces deux transistors sont connectés en série, le drain du transistor 18 étant relié à la tension de commande d'écriture $V_{PP}$ et la source transistor MOS 19 étant connectée au drain 15" du transistor MOS 15 à grille flottante formant la cellule mémoire supplémentaire. D'autre part, les grilles des transistors 18 et 19 sont connectées ensemble et reliées à un circuit d'activation. De même, la grille de commande 16 du transistor MOS à grille flottante 15 est reliée au point de connexion des grilles des transistors 18 et 19. Le circuit d'activation est constitué par une porte NI 14 alimentée par la tension de commande d'écriture $V_{PP}$. Cette porte NI 14 reçoit en entrée le signal D correspondant à la donnée en entrée et le signal $\overline{PGM}$ correspondant au signal de programmation PGM inversé. Comme représenté sur la figure 2, de manière connue, les signaux D et D entrant respectivement dans les portes NI 13 et 14 sont issus d'un registre dynamique R de type connu. La registre R permet de réaliser le stockage et le rafraichissement des données. De manière plus spécifique, il reçoit sur son entrée les données à écrire sous forme de niveau logique "1" ou "0". Il comporte essentiellement des moyens de stockage constitués par des capacités non représentées prévues devant les deux inverseurs I1 et I2 et un transistor MOS 20 commandé par le signal CLK représentant le signal herloge de la mémoire. Ce transistor MOS 20 est utilisé pour réaliser le rafraichissement des données. Ainsi, en sortie de l'inverseur I1, à savoir au noeud N1, on obtient la donnée $\overline{D}$ qui est envoyée en entrée de la porte NI 13 puis en sortie de l'inverseur I2, à savoir sur le noeud N2, on obtient la donnée D qui est envoyée en entrée de la porte NI 14.

On expliquera maintenant le fonctionnement du circuit conforme à la présente invention. Ainsi, pour programmer à "1" une cellule-mémoire du type de celle représentée à la figure 2, on applique sur sa grille de commande 5 une tension de programmation égale à $V_{PP}$ en sélectionnant ladite cellule mémoire 1 par l'intermédiaire des décodeurs 6 et 7. Dans ce cas, les transistors 8, 11 et 12 correspondent à une résistance de charge. En effet, le signal D correspondant à un niveau logique "1" et le signal PGM étant activé, on obtient un niveau logique "1" en sortie de la porte NI 13. En conséquence, les transistors MOS 11 et 12 sont passants et la tension de drain du transistor MOS à grille flottante 1 est égale à $V_{PP}-V$ charge tandis que la tension grille $V_{GP}$ est égale à $V_{PP}$. Le transistor MOS 1 se programme et l'on observe une consommation de courant sur $V_{PP}$. Pendant ce temps, la sortie de la porte NI 14 se trouve au niveau logique "0". En conséquence, les transistors 18 et 19 sont bloqués, de plus la grille de la cellule-mémoire 15 se trouve au niveau logique "0" et il n'y a aucune programmation au niveau de cette cellule.

Au contraire, si l'on désire programmer à "0" une cellule mémoire telle que le transistor MOS 1 à grille flottante, ladite cellule-mémoire 1 étant sélectionnée par l'intermédiaire des décodeurs 6 et 7, sa grille de commande 5 reçoit une tension de programmation égale à $V_{PP}$. Dans ce cas les transistors 11 et 12 sont bloqués car ils reçoivent sur leur grille un niveau logique "0" puisque $\overline{D}$ est au niveau logique "1" tandis que le signal $\overline{PGM}$ est au niveau logique "0". En conséquence, il n'est pas possible d'observer de consommation de courant sur $V_{PP}$ suite à la programmation à "0" de la cellule mémoire 1. Toutefois, la sortie de la porte NI 14 se trouve, dans ce cas, au niveau logique "1" puisque les signaux D et $\overline{PGM}$ sont au niveau logique "0". En conséquence, les transistors 18 et 19 deviennent passants, la tension sur le drain 15" de la cellule mémoire supplémentaire 15 devient égale à $V_{PP}-V$ charge et la tension sur la grille 16 est égale à $V_{PP}$. Il y a donc consommation de courant sur $V_{PP}$ puisque simulation d'une programmation à "1" sur la cellule mémoire supplémentaire 15.

En conséquence, avec le dispositif ci-dessus il est difficile de pouvoir détecter par mesure de la consommation de courant sur la tension de commande d'écriture $V_{PP}$ une programmation à "1" ou à "0". Toutefois, la simulation de programmation à "1" sur la cellule-mémoire supplémentair correspond à la programmation d'une cellule-mémoire déjà programmée. Or, une cellule-mémoire déjà programmée présente une courbe de consommation de courant légèrement différente d'une cellule-mémoire vierge. En effet, une cellule-mémoire vierge d'une mémoire non volatile de type EPROM par exemple, présente une pointe de consommation de courant d'environ 2% en début de programmation, pointe qui est pratiquement résorbée après 2 millisceondes. Toutefois, dans les mémoires EPROM on ne programme pas cellule-mémoire par cellule-mémoire mais on programme en général sur huit cellules-mémoire en parallèle. En fait, sur huit cellules-mémoire en parallèle, la différence de courant entre une cellule vierge et une cellule programmée en condition de programmation est très difficilement décelable. D'autre part, le courant moyen d'une cellule vierge en programmation et d'une cellule déjà programmée est sensiblement le même, car on positionne la droite de charge dans la zone appelée en language anglo-saxon zone "snap back" de la caractéristique.

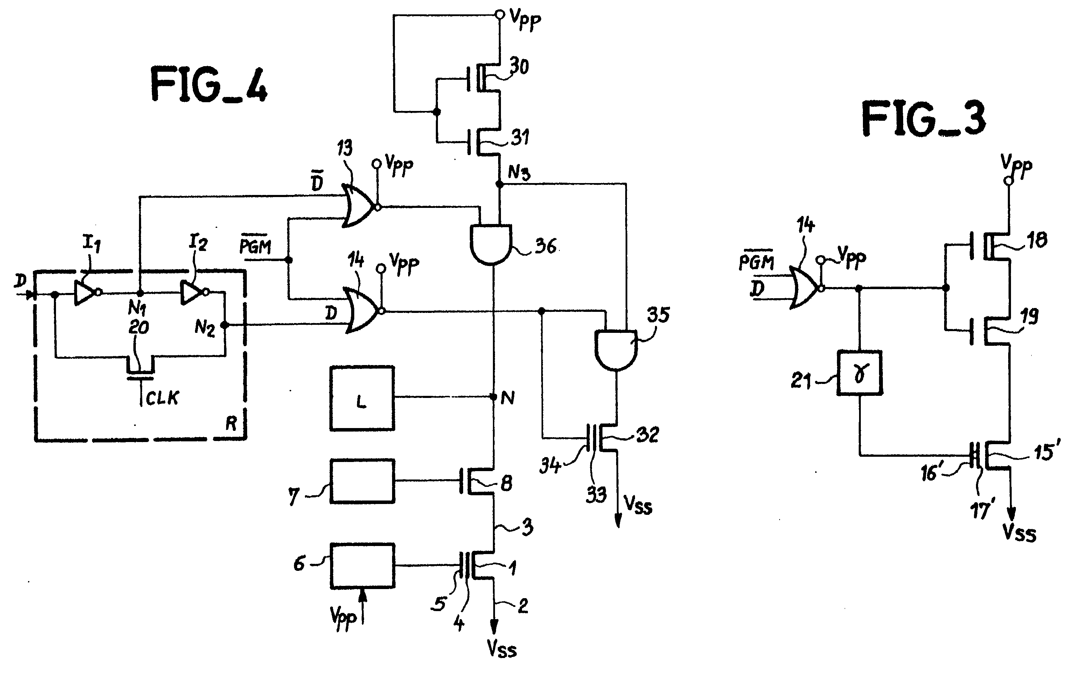

Toutefois, pour remédier à cet inconvénient la cellule-mémoire supplémentaire 15 peut être remplacée par la cellule-mémoire 15' représentée sur la figure 3. Dans ce cas, la cellule mémoire 15' est constituée par une transistor MOS à grille flottante dont la grille flottante 17' a été court-circuitée avec sa grille de commande 16'. La cellule-mémoire 15' est connectée de manière identique à la cellule-mémoire 15, c'est-à-dire que sa source est connectée à $V_{SS}$ tandis que son drain est connecté à une charge constituée par les transistors MOS 18 et 19. De même la grille de commande 16' du transistor MOS 15' est connectée au point commun avec les grilles des transistors MOS 18 et 19 en sortie de la porte NI 14. Dans ce cas la grille 16' est connectée par l'intermédiaire d'un soustracteur de tension 21 de manière à appliquer sur la cellule mémoire 15' la même tension grille-source $V_{GS}$ que sur une cellule mémoire constituée par un transistor MOS à grille flottante. Or, $V_{GS}$ égale $\gamma$ $V_{GP}$. En conséquence, la même tension grille-source pour la cellule 15' que pour une cellule normale est obtenue en utilisant le facteur $\gamma$. Aussi, au lieu d'appliquer $V_{PP}$ sur l'ensemble grille de commande 16' grille flottante 17' de la cellule supplémentaire 15', on applique une tension qui est égale à $\gamma V_{PP}$. Cette tension peut être obtenue à partir de la tension $V_{PP}$ en utilisant le circuit soustracteur de tension 21.

En fait, le circuit représenté à la figure 3 fonctionne de manière identique au circuit $E_2$ de la figure 2, la seule différence résidant en ce que la courbe du courant consommé sur $V_{PP}$ est identique à celle du courant consommé lors de la programmation à "1" d'une cellule-mémoire normale 1.

On décrira maintenant, avec référence à la figure 4, un autre mode de réalisation d'un dispositif de sécurité pour la program mation d'une mémoire non volatile programmable électriquement conforme à la présente invention. Dans le mode de réalisation de la figure 4 on n'utilise plus deux circuits d'écriture independants mais un seul et même circuit d'écriture pour écrire les cellules-mémoire normales 1 ou la cellule-mémoire supplémentaire 32. Comme représenté sur la figure 4, le transistor 1 à grille flottante est connecté au décodeur d'adresses de lignes 6, au décodeur d'adresses de colonnes 7 et au circuit de lecture L de la même manière que dans le mode de réalisation de la figure 1. Dans ce cas toutefois, le circuit d'écriture n'est pas relié directement au noeud N mais par l'intermédiaire d'une porte ET 36 qui reçoit sur une de ses entrées le signal issu de la porte NI 13 et sur l'autre entrée le signal issu du circuit d'écriture proprement dit. Le circuit d'écriture proprement dit est constitué par le transistor MOS déplété 30 et le transistor MOS enrichi 31 montés en charge. le drain du transistor MOS 30 est connecté à la tension de commande d'écriture $V_{PP}$ tandis que la source du transistor MOS 31 est reliée à l'entrée de la porte ET 36 ainsi qu'à l'entrée d'une porte ET 35 qui sera décrite ultérieurement. Les grilles des transistors 30 et 31 sont connectées ensemble et reliées à la tension de commande d'écriture $V_{PP}$. D'autre part, le circuit conforme à la présente invention comporte une cellule mémoire supplémentaire 32 constituée par un transistor MOS à grille flottante 33 dont la source est connectée à $V_{SS}$ et dont le drain est relié à la sortie de la porte ET 35 qui reçoit en entrée un signal issu du circuit d'écriture constitué par les transistors 30 et 31 et sur son autre entrée le signal issu de la porte NI 14. Les portes NI 13 et 14 sont identiques aux portes NI décrites avec référence à la figure 2 et elles fonctionnent de la même manière. D'autre part, la grille de commande 34 du transistor MOS 32 à grille flottante est reliée à la sortie de la porte NI 14. Il est évident pour l'homme de l'art que le cellule-mémoire 32 peut être constituée par un transistor MOS dont la grille flottante 33 est court-circuitée à la grille 34. Avec le circuit de la figure 4, lorsqu'une donnée D en entrée est à un niveau logique "1" la sortie de la porte NI 13 est au niveau logique "1" tandis que la sortie de la porte NI 14 est au niveau logique "0". La porte ET 36 est passante puisque le noeud N3 se trouve toujours à un niveau logique "1" correspondant à la tension $V_{PP}$. En conséquence, la cellule mémoire 1 sélectionnée par les décodeurs d'adresses de colonnes 7 et de lignes 6 se programme et l'on observe une variation de courant sur $V_{PP}$. Lorsqu'une donné D à un niveau logique "0" se trouve en entrée, alors la sortie de la porte NI 13 est à "0" bloquant le port ET 36 et la sortie de la porte NI 14 passe au niveau logique 1 correspondant à $V_{PP}$ ce qui débloque la porte ET 35 et simule une programmation à "1" sur la cellule-mémoire supplémentaire 32. Avec ce circuit, il n'est pas possible de reconnaître par détection du courant sur $V_{PP}$ si on programme un niveau logique "1" ou un niveau logique "0" à une adresse donnée.

Les circuits ci-dessus ont été donnés à titre d'exemple. Il est évident pour l'homme de l'art que d'autres modes de réalisation peuvent être utilisés pour le circuit de simulation qui correspondent aux caractéristiques données dans les revendications ci-après.

D'autre part, les états logiques "1" et "0" ont été choisis suivant une certaine convention et il est évident pour l'homme de l'art que la convention inverse aurait pu être prise. Cette convention ne limite en aucun cas la portée des revendications.

## Revendications

1. Dispositif de sécurité pour la programmation d'une mémoire non volatile programmable électriquement, la mémoire étant constituée par une matrice de cellules-mémoire (1) accessibles chacune par des lignes et des colonnes et reliées à des circuits d'écriture (E) et de lecture (L) permettant respectivement de les programmer dans deux états "1" ou "0" selon les données en entrée et de lire l'état programmé, les cellules mémoire étant du type nécessitant un courant de programmation pour être programmées dans un premier état ou "1" et ne demandant aucun courant pour être programmée dans un second état ou "0", caractérisé en ce qu'il est constitué par un circuit de simulation (E₂) activé (14) par les données correspondant à une programmation à "0" et débitant un courant identique à celui d'une cellule-mémoire en condition de programmation à "1".

2. Dispositif de sécurité selon la revendication 1, caractérisé en ce que le circuit de simulation est constitué par une cellule mémoire supplémentaire (15) connectée à un deuxième circuit d'écriture (E₂) parallèle au premier circuit d'écriture activé (14) par une donnée correspondant à une programmation à "0".

3. Dispositif de sécurité selon la revendication 1, caractérisé en ce que le circuit de simulation est constitué par une cellule mémoire supplémentaire (32) connectée au circuit d'écriture (E) de la mémoire par des moyens (14,35) permettant de recevoir un courant de programmation pour les données correspondant à une programmation à "0".

4. Dispositif de sécurité selon l'une quelconque des revendications 2 et 3, caractérisé en ce que les cellules-mémoire ainsi que la cellule-mémoire supplémentaire (15, 32) sont constituées par des transistors MOS à grille flottante.

5. Dispositif de sécurité selon l'une quelconque des revendications 2 et 3, caractérisé en ce que, les cellules-mémoire (1) étant constituées par des transistors MOS à grille flottante, la cellule mémoire supplémentaire (15′) est constituée par un transistor MOS à grille flottante dont la grille flottante est court-circuitée avec la grille de commande et qui présente la même grille-source que les autres cellules-mémoire.

6. Dispositif de sécurité selon la revendication 5, caractérisé en ce que la tension grille-source de la cellule-mémoire supplémentaire (15′) est obtenue en appliquant sur la grille de commande de cette cellule une tension de commande d'écriture égale à $\gamma$ la tension de commande d'écriture appliquée sur les autres cellules-mémoire (1), $\gamma$ étant le facteur de couplage d'un transistor à grille flottante.

7. Dispositif de sécurité selon les revendications 2 et 4 à 6, caractérisé en ce que le deuxième circuit d'écriture est constitué par une charge comprenant un transistor MOS 18 déplété monté en série avec un transistor MOS 19 enrichi, les grilles des deux transistors étant connectées en commun et reliées à un circuit d'activation (14) appliquant la tension de commande d'écriture (VPP) pour les données correspondant à une programmation à "0", la charge étant connectée entre la tension de commande d'écriture (VPP) et la cellule-mémoire supplémentaire (15) dont la grille de commande (16) est connectée avec les grilles des deux transistors de la charge.

8. Dispositif de sécurité selon la revendication 7, caractérisé en ce que le circuit d'activation est constitué par une porte NOR (14) alimentée par la tension de commande d'écriture (VPP) et recevant respectivement le signal de commande de programmation inversé $\overline{PGM}$ et la donnée à programmer D.

9. Dispositif de sécurité selon les revendications 3 à 6, caractérisé en ce que le circuit d'écriture est constitué par une charge comprenant un transistor MOS déplété (3) monté en série avec un transistor MOS enrichi (31), les grilles des deux transistors étant connectées en commun et reliées à la tension de commande d'écriture (VPP), la charge étant connectée entre la tension de commande d'écriture (VPP) et respectivement les cellules-mémoire (1) de la zone mémoire et la cellule-mémoire supplémentaire (32) par l'intermédiaire des portes ET (35, 36) ouvertes par les signaux issus des circuits d'activation (13, 14) commandés soit par les données correspondant à une programmation à "1", soit par les données correspondant à une programmation à "0".

## Patentansprüche

1. Sicherheitsschaltung zum Programmieren eines nichtflüchtigen elektrisch programmierbaren Speichers, der von einer Matrix von Speicherzellen (1) gebildet wird, auf die jeweils mittels Reihen und Spalten zugegriffen werden kann und die mit Schreibschaltungen (E) und Leseschaltungen (L) verbunden sind, welche die Programmierung der Speicherzellen in zwei Zuständen "1" oder "0" gemäß den am Eingang anliegenden Daten bzw. das Lesen des programmierten Zustandes erlauben, wobei die Speicherzellen von einer solchen Bauart sind, daß sie einen Programmierstrom benötigen, um in einen ersten Zustand oder "1" programmiert zu werden, und daß sie keinen Strom erfordern, um in einen zweiten Zustand oder "0" programmiert zu werden, dadurch gekennzeichnet, daß sie von einer Simulationsschaltung (E2) gebildet wird, die durch Daten, die einer Programmierung von "0" entsprechen, aktiviert wird (14) und einen Strom liefert, der mit demjenigen einer in einem Programmierungszustand von "1" befindlichen Speicherzelle identisch ist.

2. Sicherheitsschaltung gemäß Anspruch 1, dadurch gekennzeichnet, daß die Simulationsschaltung von einer zusätzlichen Speicherzelle (15) gebildet wird, die parallel zur ersten Schreibschaltung, welche durch Daten, die einer Programmierung von "0" entsprechen, aktiviert wird (14), mit einer zweiten Schreibschaltung (E2) verbunden ist.

3. Sicherheitsschaltung gemäß Anspruch 1, dadurch gekennzeichnet, daß die Simulationsschaltung von einer zusätzlichen Speicherzelle (32) gebildet wird, die mit der Schreibschaltung (E) des Speichers durch Mittel (14, 35) verbunden ist, die den Empfang eines Programmierstroms für die einer Programmierung von "0" entsprechenden Daten ermöglichen.

4. Sicherheitsschaltung gemäß einem der Ansprüche 2 und 3, dadurch gekennzeichnet, daß sowohl die Speicherzellen als auch die zusätzliche Speicherzelle (15, 32) von MOS-Transistoren mit schwebendem Gate gebildet werden.

5. Sicherheitsschaltung gemäß einem der Ansprüche 2 und 3, dadurch gekennzeichnet, daß bei von MOS-Transistoren mit schwebendem Gate gebildeten Speicherzellen (1) die zusätzliche Speicherzelle (15′) von einem MOS-Transistor mit schwebendem Gate gebildet wird, dessen schwebendes Gate mit dem Steuergate kurzgeschlossen ist und dessen Gate-Source-Spannung gleich derjenigen der anderen Speicherzellen ist.

6. Sicherheitsschaltung gemäß Anspruch 5, dadurch gekennzeichnet, daß die Gate-Source-Spannung der zusätzlichen Speicherzelle (15′) dadurch erhalten wird, daß an das Steuergate dieser Zelle eine Schreibsteuerspannung angelegt wird, die gleich $\gamma$ mal derjenigen Schreibsteuerspannung ist, die an die anderen Speicherzellen (1) angelegt wird, wobei $\gamma$ der Kopplungsfaktor eines Transistors mit schwebendem Gate ist.

7. Sicherheitsschaltung gemäß den Ansprüchen 2 und 4 bis 6, dadurch gekennzeichnet, daß die zweite Schreibschaltung von einer Last gebildet wird, die einen mit einem MOS-Transistor (19) vom Anreicherungstyp in Reihe geschalteten MOS-Transistor (18) vom Verarmungstyp aufweist, wobei die Gates der zwei Transistoren miteinander und mit einer Aktivierungsschaltung (14) verbunden sind, die die Schreibsteuerspannung (VPP) für die einer Programmierung von "0" entsprechenden Daten anlegt, und wobei die Last zwischen den Schreibsteuerspannungsbezugspunkt (Vpp) und die zusätzliche Speicherzelle (15), deren Steuergate mit den Gates der beiden Lasttransistoren verbunden ist, geschaltet ist.

8. Sicherheitsschaltung gemäß Anspruch 7, dadurch gekennzeichnet, daß die Aktivierungsschaltung von einer Torschaltung (NCR, 14) gebildet wird, die mit der Schreibsteuerspannung (Vpp) versorgt wird und das invertierte Programmiersteuersignal (PGM) bzw. die zu programmierenden Daten (D) empfängt.

9. Sicherheitsschaltung gemäß den Ansprüchen 3 bis 6, dadurch gekennzeichnet, daß die Schreibschaltung von einer Last gebildet wird, die einen mit einem MOS-Transistor (31) vom Anreicherungstyp in Reihe geschalteten MOS-Transistor (30) vom Verarmungstyp aufweist, wobei die Gates der zwei Transistoren miteinander und mit dem Schreibsteuerspannungsbezugspunkt (Vpp) verbunden sind und wobei die Last zwischen den Schreibsteuerspannungsbezugspunkt (Vpp) und, über dazwischengeschaltete Steuertore (36 bzw. 35), die Speicherzellen (1) der Speicherzone bzw. die zusätzliche Speicherzelle (32) geschaltet ist, wobei die Steuertore (36, 35) durch Signale geöffnet werden, die von Aktivierungsschaltungen (13, 14) ausgegeben werden, welche entweder durch einer Programmierung von "1" entsprechende Daten oder durch einer Programmierung von "0" entsprechende Daten gesteuert werden.

**Claims**

1. A security device for the programming of an electrically programmable read only memory, said memory being made up of a matrix of memory cells (1) each able to be accessed by lines and columns and connected with write (E) and read (L) circuits respectively permitting programming of same into two states "1" or "0" in accordance with the data at the input and to read the programmed state, said memory cells being of the type necessitating a programming current in order to be programmed into a first or "1" state and not requiring any current in order to be programmed into a second or "0" state, characterized in that it is constituted by a simulating circuit (E₂) activated (14) by data corresponding to programming to "0" and feeding a current identical to that of a memory cell in the programmed state "1".

2. The security device as claimed in claim 1, characterized in that the simulating circuit is constituted by a supplementary memory cell (15) connected to a second write circuit (E₂) parallel to the first write circuit (14) activated by a data item corresponding to a first programming to "0".

3. The security device as claimed in claim 1, characterized in that the simulation circuit is constituted by a supplementary memory cell (32) connected with the write circuit (E) of the memory by means (14 and 35) permitting the reception of a programming current for the data corresponding to programming to "0".

4. The security device as claimed in either of the preceding claims 2 and 3, characterized in that the memory cells and also the supplementary memory cell (15 and 32) are constituted by floating gate MOS transistors.

5. The security device as claimed in either of the preceding claims 2 and 3, characterized in that the memory cells (1) are constituted by floating gate MOS transistors, the supplementary memory cell (15') is constituted by a floating gate MOS transistor whose floating gate is short circuited with the control gate and which has the same gate-source voltage as the other memory cells.

6. The security device as claimed in claim 5, characterized in that the gate source voltage of the supplementary memory cell (15') is obtained by applying to the control gate of this cell a write control voltage equal to γ, the write control voltage applied to the other memory cells (1), γ being the coupling factor of a floating gate transistor.

7. The security device as claimed in claims 2 and 4 through 6, characterized in that the second write circuit is constituted by a load circuit comprising a depleted MOS transistor 18 placed in series with an enriched MOS transistor 19, the gates of the two transistors being connected in common and connected with an activating circuit (14) applying the write control voltage (Vpp) for the data corresponding to programming to "0", the load circuit being connected between the write control voltage (Vpp) and the supplementary memory cell (16) whose control gate (15) is connected with the gates of the two transistors of the load circuit.

8. The security device as claimed in claim 7, characterized in that the activation circuit is constituted by a NOR gate (14) supplied by the write control voltage (Vpp) and receiving respectively the inverted programming control signal PGM and the data item D to be programmed.

9. The security device as claimed in claims 3 through 6, characterized in that the write circuit is constituted by a load circuit comprising a depleted MOS transistor (30) connected in series with an enriched MOS transistor (31), the gates of the two transistors being connected in common and connected with the write control voltage (Vpp), the load circuit being connected between the write control voltage (Vpp) and, respectively, the memory cells (1) of the memory zone and the supplementary memory cell (32) by the intermediary of AND gates (35 and 36) opened by signals from activating circuits (13 and 14) controlled either by data corresponding to a programming to "1" or by data corresponding to programming to "0".

# FIG_2

# FIG_1

EP 0 269 468 B1

FIG_4

FIG_3

EP 0 269 468 B1